# EUROPÄISCHE PATENTSCHRIFT

(11) **EP 1 402 624 B1**
(45) Veröffentlichungstag und Bekanntmachung des Hinweises auf die Patenterteilung: **23.02.2005**
(21) Anmeldenummer: 02726098.3
(22) Anmeldetag: 24.05.2002
(51) Int. Cl.: H03C 1/00

(54) **ZWEI-PUNKT-MODULATOR MIT PLL-SCHALTUNG UND VEREINFACHTER DIGITALER VORFILTERUNG**
TWO-POINT MODULATOR COMPRISING A PLL CIRCUIT AND A SIMPLIFIED DIGITAL PRE-FILTERING SYSTEM
MODULATEUR DEUX POINTS AVEC CIRCUIT PLL ET PREFILTRAGE NUMERIQUE SIMPLIFIE

(30) Priorität: 07.06.2001 DE 10127612
(43) Veröffentlichungstag der Anmeldung: 31.03.2004
(73) Patentinhaber: Infineon Technologies AG, 81669 München (DE)
(72) Erfinder: GREWING, Christian, 40489 Düsseldorf (DE); HAMMES, Markus, 46539 Dinslaken (DE); WAASEN, Stefan, 47178 Duisburg (DE)
(74) Vertreter: Graf Lambsdorff, Matthias, Dr.
(86) Internationale Anmeldenummer: PCT/DE2002/001914
(87) Internationale Veröffentlichungsnummer: WO 2002/099961

(56) Entgegenhaltungen:
- EP-A- 0 408 238
- WO-A-01/11783
- WO-A-99/07065
- WO-A-99/14850
- GB-A- 2 317 512
- GB-A- 2 354 649
- US-A- 5 834 987

## Beschreibung

Die Erfindung betrifft einen Zwei-Punkt-Modulator zur Phasenoder Frequenzmodulation mit einer PLL-Schaltung, die für das Einprägen eines analogen und eines digitalen Modulationssignals ausgelegt ist. Insbesondere bezieht sich die Erfindung auf die Vorfilterung des digitalen Modulationssignals.

Eine aufwandsarme Realisierung eines Senderkonzepts für Transceiver in Mobilfunksystemen bieten Sender, welche einen nach dem bekannten Prinzip der Zwei-Punkt-Modulation arbeitenden Modulator aufweisen. Eine PLL (Phase Locked Loop = Nachlaufsynchronisations)-Schaltung wird dabei als Frequenzsynthesizer eingesetzt und zur Phasen- oder Frequenzmodulation eines hochfrequenten Signals genutzt.

Das Einprägen der Modulationssignale erfolgt üblicherweise an zwei Punkten der PLL-Schaltung. Zum einen wird ein programmierbarer Frequenzteiler der PLL-Schaltung durch ein digitales Modulationssignal angesteuert. Der programmierbare Frequenzteiler ist im Rückkoppelzweig der PLL-Schaltung angebracht und repräsentiert einen Punkt der PLL-Schaltung, an welchem sich für das Einprägen einer Modulation ein Tiefpaßübertragungsverhalten ergibt. Das digitale Modulationssignal kann dabei eine größere Bandbreite aufweisen als der durch die PLL-Schaltung gebildete Tiefpaß. Zum anderen wird in einen im Vorwärtszweig der PLL-Schaltung liegenden Summationspunkt, welcher vorzugsweise dem spannungsgesteuerten Oszillator vorgeschaltet ist, ein analoges Modulationssignal eingekoppelt. Die an dem Summationspunkt eingespeiste analoge Modulation wirkt mit einer Hochpaßfilterung durch die geschlossene Regelschleife auf den Ausgang der PLL-Schaltung, womit das entsprechende Modulationssignal wiederum durch das Übertragungsverhalten verfälscht wird. Das digitale und das analoge Modulationssignal überlagern sich am Ausgang der PLL-Schaltung, und es ergibt sich auf diese Weise ein frequenzunabhängiges Übertragungsverhalten der PLL-Schaltung. Das gleichzeitige Einprägen eines digitalen und eines analogen Modulationssignals in eine PLL-Schaltung wird als Zwei-Punkt-Modulation bezeichnet.

Ein derartiger Zwei-Punkt-Modulator sowie ein Verfahren zur Phasen- oder Frequenzmodulation mit einer PLL-Schaltung ist in der deutschen Offenlegungsschrift DE 199 29 167 A1 beschrieben. Ein digitales Modulationssignal wird in den Steueranschluß eines Frequenzteilers im Rückkoppelzweig der PLL-Schaltung eingespeist, wodurch die Zahl bestimmt wird, mit deren Kehrwert die Momentanfrequenz des Eingangssignals des Frequenzteilers multipliziert wird. Ferner wird das digitale Modulationssignal mittels eines Digital-Analog-Wandlers in ein analoges Modulationssignal umgewandelt, welches an einem einen Hochpaßpunkt repräsentierenden Summationspunkt in die PLL-Schaltung eingekoppelt wird. Diese Offenlegungsschrift ist als der zu der vorliegenden Erfindung nächstliegende Stand der Technik anzusehen.

Bei der beschriebenen Art des Senderkonzepts bleibt die Regelschleife geschlossen. Um ein geringes Rauschen der PLL-Schaltung zu erzielen, wird die Bandbreite der PLL-Schaltung deutlich kleiner ausgelegt, als es für die Übertragung der modulierten Daten erforderlich wäre. Zur Kompensation der geringen Bandbreite wird neben dem digitalen Modulationssignal das analoge Modulationssignal in die PLL-Schaltung eingekoppelt.

Sowohl das digitale als auch das analoge Modulationssignal werden zur Begrenzung des Ausgangsspektrums der PLL-Schaltung vorgefiltert. Die Filterung des digitalen Modulationssignals wird in der Regel durch Überabtastung vorgenommen, d.h. ein Bit wird durch mehrere Samples repräsentiert. Des weiteren muß für die einwandfreie Funktion der Zwei-Punkt-Modulation neben der zeitlichen Gleichphasigkeit ein hohes Maß an Übereinstimmung der Amplituden der beiden Modulationssignale gewährleistet sein. Bei bekannten Zwei-Punkt-Modulatoren werden aus diesem Grund für die digitale und die analoge Vorfilterung Filter mit gleicher Impulsformung verwendet. Nachteilig daran ist der entsprechend hohe Realisierungsaufwand für derartige digitale und analoge Filter.

In der europäischen Patentanmeldung EP 0 408 238 A2 ist ein Zwei-Punkt-Modulator mit einer PLL-Schaltung offenbart. Vor der Einspeisung des digitalen Modulationssignals in die PLL-Schaltung mittels eines Frequenzteilers wird das digitale Modulationssignal bei diesem Zwei-Punkt-Modulator einem Verzögerungsglied und nachfolgend einem Integrator zugeführt.

Aufgabe der Erfindung ist es daher, einen Zwei-Punkt-Modulator zur Phasen- oder Frequenzmodulation mit einer PLL-Schaltung zu schaffen, bei welchem die zur Vorfilterung des digitalen und des analogen Modulationssignals verwendeten Filter unterschiedliche Impulsformungen aufweisen können und zumindest einer der beiden Filter einen möglichst geringen Realisierungsaufwand aufweisen soll, ohne daß dabei das Sendespektrum des Zwei-Punkt-Modulators wesentlich verändert wird.

Die der Erfindung zugrundeliegende Aufgabenstellung wird durch die Merkmale der unabhängigen Patentansprüche gelöst. Vorteilhafte Weiterbildungen und Ausgestaltungen sind in den Unteransprüchen angegeben.

Ein erfindungsgemäßer Zwei-Punkt-Modulator, der zur Phasenoder Frequenzmodulation eingesetzt wird, weist eine PLL-Schaltung auf. Des weiteren umfaßt der Zwei-Punkt-Modulator einen ersten Schaltungszweig, durch welchen ein analoges Modulationssignal in einen ersten Punkt der PLL-Schaltung eingeprägt wird. Die Lage des ersten Punkts ist dabei derart gewählt, daß das analoge Modulationssignal, das an diesem Punkt in die PLL-Schaltung eingespeist wird, mit einer Hochpaßfilterung durch die geschlossene Regelschleife auf den Ausgang der PLL-Schaltung wirkt. Vorteilhafterweise befindet sich der erste Punkt vor einem in einer PLL-Schaltung enthaltenen spannungsgesteuerten Oszillator. Des weiteren umfaßt der Zwei-Punkt-Modulator einen zweiten Schaltungszweig, durch welchen ein digitales Modulationssignal in einen zweiten Punkt der PLL-Schaltung eingeprägt wird. Der zweite Schaltungszweig ist mit dem Steueranschluß eines Frequenzteilers verbunden, welcher bei Zwei-Punkt-Modulatoren in dem Rückkoppelzweig der PLL-Schaltung enthalten ist. Dadurch wirkt das digitale Modulationssignal, welches den Frequenzteiler ansteuert und somit die zur Frequenzteilung benötigte Zahl vorgibt, mit einer Tiefpaßfilterung auf den Ausgang der PLL-Schaltung. Ein wesentlicher Gedanke der Erfindung besteht darin, daß der zweite Schaltungszweig ein digitales Filter enthält, welches eine rechteckförmige Impulsantwort aufweist, d.h. im Frequenzraum weist das digitale Filter durch die Überabtastung im Durchlaßbereich des durch die PLL-Schaltung gebildeten Tiefpasses ein nahezu konstantes Übertragungsverhalten auf. Die Übertragungsfunktion des digitalen Filters ist dadurch gekennzeichnet, daß ein am Eingang des digitalen Filters empfangener Wert, welcher beispielsweise in einem Register gespeichert wurde, am Ausgang des digitalen Filters mehrfach ausgegeben wird.

Die Realisierung des im zweiten Schaltungszweig enthaltenen digitalen Filters durch einen digitalen Filter mit rechteckförmiger Impulsantwort kann aufgrund der geringen Bandbreite der geschlossenen PLL-Regelschleife erfolgen. In der Regel unterscheiden sich die Übertragungsfunktionen eines normalerweise für diese Zwecke verwendeten digitalen Filters und eines digitalen Filters mit rechteckförmiger Impulsantwort innerhalb der geringen Bandbreite der PLL-Regelschleife nicht wesentlich. Daher kann aufgrund der vorliegenden Erfindung das bisher eingesetzte aufwendige digitale Filter, dessen Impulsantwort häufig die Form einer Gaußkurve aufweist, durch ein einfaches digitales Filter mit rechteckförmiger Impulsantwort (Rechteckfilter) ersetzt werden, ohne daß ein wesentlicher Unterschied in dem Sendespektrum des Zwei-Punkt-Modulators erkennbar wäre. Der erste Schaltungszweig bleibt von dieser Erfindung unberührt.

Wie bei bekannten Zwei-Punkt-Modulatoren mit PLL-Schaltungen kann weiterhin vorgesehen sein, daß der erste Schaltungszweig ein Filter enthält, welches beispielsweise ein analoges Filter sein kann. Die Impulsformung des im ersten Schaltungszweig enthaltenen Filters kann sich von der erfindungsgemäßen rechteckigen Impulsformung des digitalen Filters unterscheiden. Es kann ferner vorgesehen sein, daß die Filterung des durch den ersten Schaltungszweig übertragenen Modulationssignals auch im Digitalbereich mit einer nachfolgenden Digital-Analog-Wandelung erfolgt.

Eine weitere vorteilhafte Ausgestaltung der Erfindung sieht vor, daß die Amplitude der Impulsantwort des digitalen Filters mittels einer Einheit gesteuert werden kann. Dadurch kann bei Bedarf die Amplitude des digitalen Modulationssignals und damit der Modulationsindex auf einfache Weise angepaßt werden. Bei bekannten Zwei-Punkt-Modulatoren mit gleicher Filterfunktion für die digitale und die analoge Filterung ist es demgegenüber notwendig, jeden Filterkoeffizienten einzeln anzupassen, bzw. eine zusätzliche Multiplikation oder Division mit entsprechenden Rundungsoperationen vorzunehmen.

Ein weiterer Aspekt der Erfindung betrifft ein Verfahren zur Phasen- oder Frequenzmodulation mit einer PLL-Schaltung, welche nach dem Prinzip der Zwei-Punkt-Modulation arbeitet. Bei dem erfindungsgemäßen Verfahren wird ein analoges Modulationssignal an einem ersten Punkt in die PLL-Schaltung eingekoppelt. Der erste Punkt muß der Bedingung genügen, daß sich dort ein Hochpaßübertragungsverhalten für eine eingekoppelte Modulationsfrequenz ergibt. Ein digitales Modulationssignal durchläuft zunächst ein digitales Filter und wird anschließend an einem zweiten Punkt in die PLL-Schaltung eingekoppelt. Dabei steuert das digitale Modulationssignal einen in einen Rückkoppelzweig der PLL-Schaltung eingebundenen Frequenzteiler an, an welchem sich ein Tiefpaßübertragungsverhalten für das digitale Modulationssignal ergibt. Das erfindungsgemäße Verfahren ist dadurch gekennzeichnet, daß das digitale Filter eine rechteckförmige Impulsantwort aufweist. Die Übertragungsfunktion des digitalen Filters ist dadurch gekennzeichnet, daß ein am Eingang des digitalen Filters empfangener Wert, welcher beispielsweise in einem Register gespeichert wurde, am Ausgang des digitalen Filters mehrfach ausgegeben wird.

Ein Vorteil des erfindungsgemäßen Verfahrens ist der geringe Realisierungsaufwand für die digitale Filterung. Wegen der geringen Bandbreite der geschlossenen PLL-Regelschleife unterscheiden sich die Übertragungsfunktionen eines normalerweise verwendeten digitalen Filters, welches die gleiche Impulsform wie ein üblicherweise für die Filterung des analogen Modulationssignals verwendetes Filter aufweist, und eines digitalen Filters mit rechteckförmiger Impulsantwort innerhalb der Bandbreite der PLL-Regelschleife nicht wesentlich. Daher ist kein wesentlicher Unterschied in dem Sendespektrum der PLL-Schaltung erkennbar.

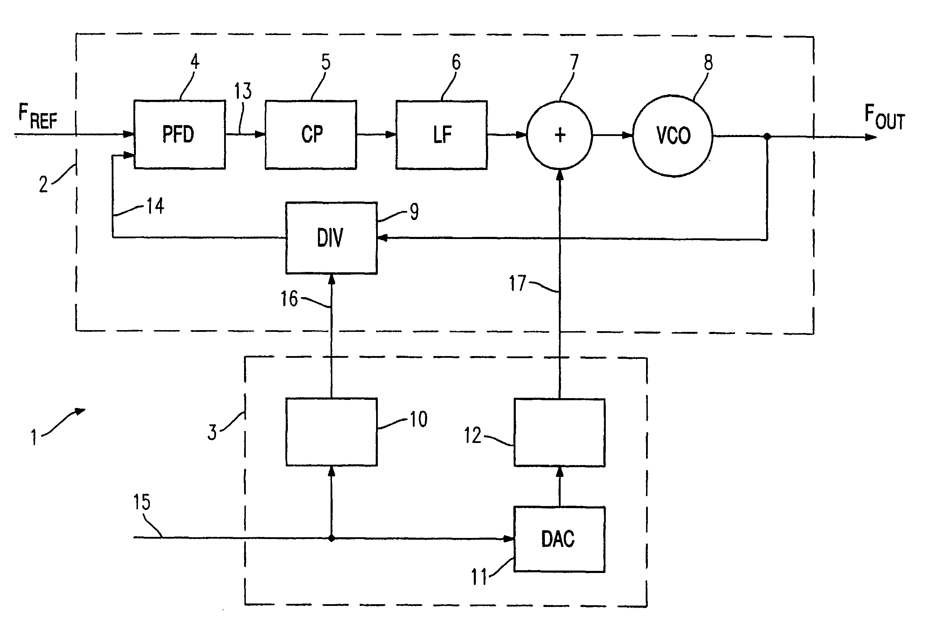

Die Erfindung wird nachfolgend in beispielhafter Weise anhand eines in einer Zeichnung dargestellten Ausführungsbeispiels erläutert. Die einzige Figur zeigt ein schematisches Schaltbild eines Zwei-Punkt-Modulators mit einem PLL-Schaltkreis und einem Modulationsschaltkreis.

Die Figur zeigt einen Zwei-Punkt-Modulator 1 mit einer PLL-Schaltung 2. Durch die PLL-Schaltung 2 wird ein Ausgangssignal mit einer Ausgangsfrequenz F_{OUT} aus einem Eingangs- oder Referenzsignal mit einer Referenzfrequenz F_{REF} erzeugt. Das Ausgangssignal mit der Ausgangsfrequenz F_{OUT} ist durch ein digitales Modulationssignal 16 und ein analoges Modulationssignal 17 modulierbar.

Der Zwei-Punkt-Modulator 1 umfaßt neben der PLL-Schaltung 2 eine an geeigneten Punkten an die PLL-Schaltung 2 gekoppelte Modulationsschaltung 3, mittels welcher die Modulation des Ausgangssignals der PLL-Schaltung 2 vorgenommen wird.

Die PLL-Schaltung 2 enthält einen Phasendetektor PFD (Phase Frequency Detector) 4, welchem an seinen Eingängen das Referenzsignal mit der Referenzfrequenz F_{REF} und ein rückgekoppeltes Frequenzteilersignal 14 zugeführt wird. Das Referenzsignal wird beispielsweise von einem Schwingquarz abgeleitet. Der Phasendetektor 4 vergleicht die Phasen der beiden eingangsseitig eingehenden Signale und erzeugt ausgangsseitig ein Steuersignal 13, welches der Phasendifferenz der beiden in seine Eingänge eingehenden Signale entspricht. Das Steuersignal 13 wird in einen Eingang einer Ladungspumpe CP (Charge Pump) 5 eingegeben. Die Ladungspumpe 5 generiert in Abhängigkeit von dem Steuersignal 13 einen Strom zum Aufladen eines der Ladungspumpe 5 nachgeschalteten Schleifenfilters LF (Loop Filter) 6. Das Schleifenfilter 6 enthält einen integrierenden Teil und einen Tiefpaß zur Glättung des Steuersignals 13. Das von dem Schleifenfilter 6 ausgegebene Signal durchläuft einen Summationspunkt 7, welcher zur Einkoppelung des analogen Modulationssignals 17 dient, und wird anschließend einem spannungsgesteuerten Oszillator VCO (Voltage Controlled Oscillator) 8 zugeführt. Der spannungsgesteuerte Oszillator 8 repräsentiert das schwingungserzeugende Glied der PLL-Schaltung 2 und generiert das Ausgangssignal der PLL-Schaltung, welches die Ausgangsfrequenz F_{OUT} aufweist.

Die Regelschleife der PLL-Schaltung 2 wird durch einen Rückkoppelzweig geschlossen. Der Rückkoppelzweig führt das Ausgangssignal des spannungsgesteuerten Oszillators 8 über einen programmierbaren Frequenzteiler DIV (Divider) 9 einem Eingang des Phasendetektors 4 zu. Üblicherweise ist der programmierbare Frequenzteiler 9 als Multi-Modulus Frequenzteiler (Multi Modulus Frequency Divider) ausgeführt. Im eingeschwungenen Zustand der PLL-Schaltung 2 entspricht die Ausgangsfrequenz F_{OUT} des Ausgangssignals exakt dem durch den programmierbaren Frequenzteiler 9 bestimmten Vielfachen der Referenzfrequenz F_{REF}.

Die Wirkungsweise des Zwei-Punkt-Modulators 1 ist bekannt. Bei der Zwei-Punkt-Modulation werden in die PLL-Schaltung 2 mittels der Modulationsschaltung 3 das digitale Modulationssignal 16 und das analoge Modulationssignal 17 eingeprägt. In der Figur ist ein Beispiel einer Modulationsschaltung 3 dargestellt, durch welche das digitale und das analoge Modulationssignal 16 und 17 aufbereitet und der PLL-Schaltung 2 zugeführt werden. Die vorliegende, beispielhafte Modulationsschaltung 3 umfaßt ein digitales Filter 10, einen Digital-Analog-Wandler DAC (Digital to Analog Converter) 11 und ein analoges Filter 12.

Die Modulationsschaltung 3 wird an einem Eingang mit einem Modulationssignal 15 gespeist, welches in dem vorliegenden Ausführungsbeispiel ein digitales Signal ist. Das Modulationssignal 15 wird dem digitalen Filter 10 zugeführt, welches ein Tiefpaßfilter ist. Nach der Glättung durch das digitale Filter 10 speist das digitale Modulationssignal 16 einen Steuereingang des programmierbaren Frequenzteilers 9. Beispielsweise weist das digitale Modulationssignal 16 eine Folge von Datenwörtern auf, wobei jedes Datenwort ein Zahl repräsentiert. Bei Erhalt eines jeden Datenworts über seinen Steuereingang wird der programmierbare Frequenzteiler 9 derart programmiert, daß er die von dem spannungsgesteuerten Oszillator 8 erhaltene Frequenz F_{OUT} mit dem Kehrwert der erhaltenen Zahl multipliziert.

Das Modulationssignal 15 wird des weiteren dem Digital-Analog-Wandler 11 zugeführt und durchläuft nach seiner Umwandlung in den Analogbereich das analoge Filter 12. Anschließend speist das am Ausgang des analogen Filters 12 auskoppelbare analoge Modulationssignal 17 einen Eingang des Summationspunkts 7.

Das Einbringen der Modulation über den programmierbaren Frequenzteiler 9 in die PLL-Schaltung 2 bewertet das Modulationssignal 15 mit einer Tiefpaßfunktion. Dadurch wird das Signal auf eine Bandbreite eingeschränkt, die im allgemeinen kleiner als die Modulationsbandbreite ist. Jedoch ist ein im wesentlichen frequenzunabhängiges Übertragungsverhalten der PLL-Schaltung 2 erwünscht. Deswegen wird die Modulation an einem Punkt mit Hochpaßübertragungsverhalten in die PLL-Schaltung 2 eingespeist. Dieses geschieht in der vorliegenden PLL-Schaltung 2 in dem Summationspunkt 7. Dort wird das analoge Modulationssignal 17 dem aufbereiteten Steuersignal 13 überlagert, so daß die Summe beider Signale den spannungsgesteuerten Oszillator 8 steuert.

Um eine möglichst hohe spektrale Effizienz des Ausgangssignals des spannungsgesteuerten Oszillators 8 zu erzielen, werden das digitale Modulationssignal 16 mittels des digitalen Filters 10 und das analoge Modulationssignal 17 mittels des analogen Filters 12 vorgefiltert. Erfindungsgemäß wird dafür ein digitales Filter 10 mit einer Rechteckimpulsformung verwendet. Wegen der geringen Bandbreite der geschlossenen PLL-Schaltung 2 kann bei dem vorliegenden Zwei-Punkt-Modulator 1 ein derartiges digitales Filter 10 Verwendung finden, ohne daß das Sendspektrum des Zwei-Punkt-Modulators 1 negativ beeinträchtigt wird. Es ist auch nicht notwendig, daß das digitale Filter 10 und das analoge Filter 12 die gleiche Impulsformung aufweisen.

## Patentansprüche

1. Zwei-Punkt-Modulator (1) zur Phasen- oder Frequenzmodulation mit einer PLL-Schaltung (2), welcher einen ersten Schaltungszweig für das Einprägen eines analogen Modulationssignals (17) in einen ersten Punkt der PLL-Schaltung (2) mit Hochpaßübertragungsverhalten und einen zweiten Schaltungszweig für das Einprägen eines digitalen Modulationssignals (16) in einen zweiten Punkt der PLL-Schaltung (2) mit Tiefpaßübertragungsverhalten aufweist, wobei
- der zweite Schaltungszweig mit einem Steueranschluß eines in einem Rückkoppelzweig der PLL-Schaltung (2) enthaltenen Frequenzteilers (9) verbunden ist,
**dadurch gekennzeichnet,**
- **daß** der zweite Schaltungszweig ein digitales Filter (10) umfaßt, welches eine rechteckförmige Impulsantwort derart aufweist, daß es einen an seinem Eingang empfangenen Wert, welcher insbesondere in einem Register abgelegt wird, innerhalb des Rechteckfensters mehrfach ausgibt.

2. Zwei-Punkt-Modulator (1) nach Anspruch 1,
**dadurch gekennzeichnet,**
- **daß** der erste Schaltungszweig ein weiteres Filter, insbesondere ein analoges Filter (12), umfaßt.

3. Zwei-Punkt-Modulator (1) nach einem oder mehreren der vorhergehenden Ansprüche,
**dadurch gekennzeichnet,**
- **daß** das digitale Filter (10) eine Einheit zur Steuerung der Amplitude der Impulsantwort aufweist.

4. Zwei-Punkt-Modulator (1) nach einem oder mehreren der vorhergehenden Ansprüche,
**dadurch gekennzeichnet,**
- **daß** die PLL-Schaltung (2) folgende Merkmale aufweist:
- einen spannungsgesteuerten Oszillator (8) zur Bereitstellung eines phasen- oder frequenzmodulierten Ausgangssignals an seinem Ausgang,
- einen Phasendetektor (4) zur Ermittlung einer Phasendifferenz zwischen einem von dem Ausgangssignal abgeleiteten Rückkoppelsignal (14) und einem Referenzsignal und zur Ansteuerung des spannungsgesteuerten Oszillators (8) in Abhängigkeit von der ermittelten Phasendifferenz, und
- einen Rückkoppelzweig zur Bereitstellung des Rückkoppelsignals (14), wobei der Rückkoppelzweig den Frequenzteiler (9) enthält.

5. Zwei-Punkt-Modulator (1) nach Anspruch 4,
**dadurch gekennzeichnet,**
- **daß** der erste Punkt der PLL-Schaltung (2) ein Summationspunkt (7) ist, der dem spannungsgesteuerten Oszillator (8) vorgeschaltet ist.

6. Verfahren zur Phasen- oder Frequenzmodulation nach dem Prinzip der Zwei-Punkt-Modulation mit einer PLL-Schaltung (2), bei welchem
- ein analoges Modulationssignal (17) an einem ersten Punkt in die PLL-Schaltung (2) eingekoppelt wird, an welchem sich ein Hochpaßübertragungsverhalten für eine Modulationsfrequenz ergibt, und
- ein digitales Modulationssignal (16) an einem zweiten Punkt in die PLL-Schaltung (2) eingekoppelt wird, wobei das digitale Modulationssignal (16) einen in einen Rückkoppelzweig der PLL-Schaltung (2) eingebundenen Frequenzteiler (9) ansteuert, an welchem sich ein Tiefpaßübertragungsverhalten für eine Modulationsfrequenz ergibt,
**dadurch gekennzeichnet,**
- **daß** das digitale Modulationssignal (16) vor der Einkoppelung an dem zweiten Punkt einer digitalen Filterung (10) unterworfen wird, welche eine rechteckförmige Impulsantwort derart aufweist, dass ein empfangener Wert von einem Modulationssignal (15), welcher insbesondere in einem Register abgelegt wurde, innerhalb des Rechteckfensters mehrfach ausgegeben wird.

7. Verfahren nach Anspruch 6,
**dadurch gekennzeichnet,**
- **daß** das analoge Modulationssignal (17) vor der Einkoppelung in die PLL-Schaltung (2) einer analogen Filterung (12) unterworfen wird.

8. Verfahren nach Anspruch 6 oder 7,
**dadurch gekennzeichnet,**
- **daß** die Amplitude der Impulsantwort der digitalen Filterung (10) gesteuert werden kann.

9. Verfahren nach einem oder mehreren der Ansprüche 6 bis 8,
**dadurch gekennzeichnet,**
- **daß** die PLL-Schaltung (2) folgende Merkmale aufweist:
- einen spannungsgesteuerten Oszillator (8) zur Bereitstellung eines phasen- oder frequenzmodulierten Ausgangssignals an seinem Ausgang,
- einen Phasendetektor (4) zur Ermittlung einer Phasendifferenz zwischen einem von dem Ausgangssignal abgeleiteten Rückkoppelsignal (14) und einem Referenzsignal und zur Ansteuerung des spannungsgesteuerten Oszillators (8) in Abhängigkeit von der ermittelten Phasendifferenz, und
- einen Rückkoppelzweig zur Bereitstellung des Rückkoppelsignals (14), wobei der Rückkoppelzweig den Frequenzteiler (9) enthält.

10. Verfahren nach einem oder mehreren der Ansprüche 6 bis 9,
**dadurch gekennzeichnet,**
- **daß** das analoge Modulationssignal (17) in einen Summationspunkt (7) der PLL-Schaltung (2), welcher dem spannungsgesteuerten Oszillator (8) vorgeschaltet ist, eingekoppelt wird.

## Claims

1. Two-point modulator (1) for phase or frequency modulation with a PLL circuit (2) which has a first circuit path for impressing an analogue modulation signal (17) into a first point in the PLL circuit (2) with a high-pass response and a second circuit path for impressing a digital modulation signal (16) into a second point in the PLL circuit (2) with a low-pass response, where
- the second circuit path is connected to a control connection on a frequency divider (9) contained in a feedback path in the PLL circuit (2),
**characterized**
- **in that** the second circuit path comprises a digital filter (10) which has a square-wave impulse response such that it outputs a value received at its input, which value is stored in a register, in particular, a plurality of times within the square-wave window.

2. Two-point modulator (1) according to Claim 1,
**characterized**
- **in that** the first circuit path comprises a further filter, particularly an analogue filter (12).

3. Two-point modulator (1) according to one or more of the preceding claims,
**characterized**
- **in that** the digital filter (10) has a unit for controlling the amplitude of the impulse response.

4. Two-point modulator (1) according to one or more of the preceding claims,
**characterized**
- **in that** the PLL circuit (2) has the following features:
- a voltage controlled oscillator (8) for providing a phase- or frequency-modulated output signal at its output,
- a phase detector (4) for ascertaining a phase difference between a feedback signal (14), derived from the output signal, and a reference signal and for actuating the voltage controlled oscillator (8) on the basis of the ascertained phase difference, and
- a feedback path for providing the feedback signal (14), the feedback path containing the frequency divider (9).

5. Two-point modulator (1) according to Claim 4,
**characterized**
- **in that** the first point in the PLL circuit (2) is a summation point (7) which is connected upstream of the voltage controlled oscillator (8).

6. Method for phase or frequency modulation on the basis of the principle of two-point modulation with a PLL circuit (2), in which
- an analogue modulation signal (17) is injected into the PLL circuit (2) at a first point, at which a high-pass response is obtained for a modulation frequency, and
- a digital modulation signal (16) is injected into the PLL circuit (2) at a second point, the digital modulation signal (16) actuating a frequency divider (9) which is incorporated in a feedback path in the PLL circuit (2) and on which a low-pass response is obtained for a modulation frequency.
**characterized**
**in that** the digital modulation signal (16) is subjected, before injection at the second point to digital filtering (10) which has a square-wave impulse response such that a received value from a modulation signal (15), which value has been stored in a register, in particular, is output a plurality of times within the square-wave window.

7. Method according to Claim 6,
**characterized**
- **in that** the analogue modulation signal (17) is subjected to analogue filtering (12) before injection into the PLL circuit (2).

8. Method according to Claim 6 or 7,
**characterized**
- **in that** the amplitude of the impulse response of the digital filtering (10) can be controlled.

9. Method according to one or more of Claims 6 to 8,
**characterized**
- **in that** the PLL circuit (2) has the following features:
- a voltage controlled oscillator (8) for providing a phase- or frequency-modulated output signal at its output,
- a phase detector (4) for ascertaining a phase difference between a feedback signal (14), derived from the output signal, and a reference signal and for actuating the voltage controlled oscillator (8) on the basis of the ascertained phase difference, and
- a feedback path for providing the feedback signal (14), the feedback path containing the frequency divider (9).

10. Method according to one or more of Claims 6 to 9,
**characterized**
- **in that** the analogue modulation signal (17) is injected into a summation point (7) in the PLL circuit (2), which summation point is connected upstream of the voltage controlled oscillator (8).

## Revendications

1. Modulateur (1) à deux points pour la modulation de phase ou de fréquence, comprenant un circuit (2) PLL qui a une première branche de circuit pour l'application d'un signal (17) analogique de modulation dans un premier point du circuit (2) PLL ayant un comportement de transmission passe-haut et une deuxième branche de circuit pour l'application d'un signal (16) numérique de modulation dans un deuxième point du circuit (2) PLL ayant un comportement de transmission passe-bas, dans lequel
- la deuxième branche du circuit est reliée à une borne de commande d'un diviseur (9) de fréquence contenue dans une branche de réaction du circuit (2) PLL,
**caractérisé**
- **en ce que** la deuxième branche du circuit comprend un filtre (10) numérique qui a une réponse impulsionnelle rectangulaire de sorte qu'il est émis plusieurs fois dans une fenêtre rectangulaire une valeur reçue à son entrée, qui est mise notamment dans un registre.

2. Modulateur (1) à deux points suivant la revendication 1,
**caractérisé**
- **en ce que** la première branche de circuit comprend un autre filtre, notamment un filtre (12) analogique.

3. Modulateur (1) à deux points suivant l'une ou plusieurs des revendications précédentes,
**caractérisé**
- **en ce que** le filtre (10) numérique a une unité de commande de l'amplitude de la réponse impulsionnelle.

4. Modulateur (1) à deux points suivant l'une ou plusieurs des revendications précédentes,
**caractérisé**
- **en ce que** le circuit (2) PLL a les caractéristiques suivantes :
- un oscillateur (8) commandé par une tension pour la mise à disposition à sa sortie d'un signal de sortie modulé en phase ou en fréquence ;
- un détecteur (4) de phase pour déterminer une différence de phase entre un signal (14) de réaction dérivé du signal de sortie et un signal de référence et pour commander l'oscillateur (8) commandé par une tension en fonction de la différence de phase déterminée ; et
- une branche de réaction pour la mise à disposition du signal (14) de réaction, la branche de réaction comportant le diviseur (9) de fréquence.

5. Modulateur (1) à deux points suivant la revendication 4,
**caractérisé**
- **en ce que** le premier point du circuit (2) PLL est un point (7) de sommation, qui est monté en amont de l'oscillateur (8) commandé en tension.

6. Procédé de modulation de phase ou de fréquence suivant le principe de la modulation à deux points par un circuit (2) PLL, dans lequel
- on injecte un signal (17) analogique de modulation en un premier point dans le circuit (2) PLL où il y a un comportement de transmission passe-bas pour une fréquence de modulation, et
- on injecte un signal (16) numérique de modulation en un deuxième point dans le circuit (2) PLL, le signal (16) numérique de modulation commandant un diviseur (9) de fréquence incorporé dans une branche de réaction du circuit (2) PLL où il y a un comportement de transmission passe-haut pour une fréquence de modulation,
**caractérisé**
- **en ce que** l'on soumet le signal (16) numérique de modulation, avant l'injection au deuxième point, à un filtrage (10) numérique qui comporte une réponse impulsionnelle rectangulaire de sorte qu'une valeur reçue d'un signal (15) de modulation, qui a été mise notamment dans un registre, est émise plusieurs fois dans la fenêtre rectangulaire.

7. Procédé suivant la revendication 6,
**caractérisé**
- **en ce que** l'on soumet le signal (17) analogique de modulation, avant l'injection dans le circuit (2) PLL, à un filtrage (12) analogique.

8. Procédé suivant la revendication 6 ou 7,
**caractérisé**
- **en ce que** l'on peut commander l'amplitude de la réponse impulsionnelle du filtrage (10) numérique.

9. Procédé suivant l'une ou plusieurs des revendications 6 à 8,
**caractérisé**
- **en ce que** le circuit (2) PLL a les caractéristiques suivantes :
- un oscillateur (8) commandé par une tension pour la mise à disposition à sa sortie d'un signal de sortie modulé en phase ou en fréquence ;
- un détecteur (4) de phase pour déterminer une différence de phase entre un signal (14) de réaction dérivé du signal de sortie et un signal de référence et pour commander l'oscillateur (8) commandé par une tension en fonction de la différence de phase déterminée, et
- une branche de réaction pour la mise à disposition du signal (14) de réaction, la branche de réaction comportant le diviseur (9) de fréquence.

10. Procédé suivant l'une ou plusieurs des revendications 6 à 9,
**caractérisé**
- **en ce que** l'on injecte le signal (17) analogique de modulation dans un point (7) de sommation du circuit (2) PLL, qui est en amont de l'oscillateur (18) commandé en tension.
